# EUROPÄISCHE PATENTSCHRIFT

(11) **EP 1 099 009 B1**
(45) Veröffentlichungstag und Bekanntmachung des Hinweises auf die Patenterteilung: **03.04.2002**
(21) Anmeldenummer: 99936518.2
(22) Anmeldetag: 13.07.1999
(51) Int. Cl.: C23C 28/02

(54) **VERFAHREN ZUR BESCHICHTUNG VON KÖRPERN AUS LEICHTMETALLEN ODER LEICHTMETALLEGIERUNGEN MITTELS PLASMAUNTERSTÜTZUNG**
METHOD FOR COATING BODIES MADE OF LIGHT METAL OR LIGHT METAL ALLOYS BY MEANS OF A PLASMA ENHANCED PROCESS
PROCEDE POUR LE REVETEMENT DE CORPS EN METAUX LEGERS OU EN ALLIAGES DE METAUX LEGERS AU MOYEN D'UN PROCEDE ACTIVE PAR UN PLASMA

(30) Priorität: 13.07.1998 DE 19831370
(43) Veröffentlichungstag der Anmeldung: 16.05.2001
(73) Patentinhaber: Fraunhofer-Gesellschaft zur Förderung der angewandten Forschung e.V., 80636 München (DE)
(72) Erfinder: GRÖNINGER, Heinz-Bernhard, D-49733 Haren (DE); VON DER HEIDE, Volker, D-22455 Hamburg (DE)
(74) Vertreter: Einsel, Martin
(86) Internationale Anmeldenummer: EP9904894
(87) Internationale Veröffentlichungsnummer: WO0004209

(56) Entgegenhaltungen:
- WO-A-91/03583

## Beschreibung

Die Erfindung betrifft ein Verfahren zur Beschichtung von Körpern aus Leichtmetallen oder Leichtmetallegierungen mittels Plasmaunterstützung.

Beschichtungsverfahren, die mittels Plasmaunterstützung arbeiten, sind in vielen Varianten bekannt. Durch das Anlegen einer Gleich- oder Wechselspannung an zwei Elektroden in einer mit einern Inertgas, beispielsweise Argon, gefüllten Prozeßkammer, wird ein Plasma, eine Gasentladung, erzeugt. Das Plasma sorgt einerseits für die Erzeugung und Aktivierung der für ein gutes Schichtwachstum notwendigen lonen, andererseits wird bei einigen Prozessen dadurch auch gleichzeitig das benötigte Material zum Aufbau der Schichten erzeugt. So wird bei den als CVD-(Chemical Vapour Deposition, Gasphasenabscheide-) Verfahren bezeichneten Prozessen z. B. ein sogenannter zugeführter Precurser mit Hilfe des Plasmas in die schichtbildenden Komponenten zersetzt. Bei den PVD (Physical Vapour Deposition)-Verfahren wird der Feststoff des Schichtmaterials im Plasma, z. B. durch Kathodenzerstäubung, atomisiert. Die erzeugten Atome scheiden sich auf einem in der Prozeßkammer entsprechend angebrachten Substrat, nämlich dem zu beschichtenden Körper, als Schicht ab.

Zudem besteht die Möglichkeit, durch Einbringen eines Reaktivgases in die Prozeßkammer weitere Komponenten zur Schichtbildung beizuführen. Plasmaunterstutzte Beschichtungsprozesse zeichnen sich besonders durch eine hohe Schichtreinheit, eine große Vielfalt an möglichen Schichtmaterialien und variierbare Schichteigenschaften aus.

Ein regelmäßiges Problem bei beschichteten metallischen Körpern besteht in einer häufig unzureichenden Haftfestigkeit der Schichten auf dem Substrat oder Grundwerkstoff, also dem eigentlichen Körper. Auch der Korrosionsschutz ist häufig nur unzureichend gewährleistet. So kann im einfachsten Fall beispielsweise Wasser durch die Schicht auf das Substrat permeieren. Dadurch kommt es zur Korrosion und letztlich zum Versagen des Schichtsystems, das einfach abplatzt. Dies wird durch ungenügende Haftfestigkeit noch verstärkt. Eine Reihe von Ansätzen wurde schon unternommen, um plasmaunterstützte Beschichtungsverfahren gerade zur Lösung dieser Probleme weiterzuentwickeln. Für viele industrierelevante Anwendungsfälle sind die erzielten Ergebnisse aber noch nicht ausreichend.

Zur Verbesserung der Haftfestigkeit von stromlos abgeschiedenen Metallschichten auf Oxidschichten wird in der WO 91/03583 vorgeschlagen, als Haftvermittler ein erstes Metall elektrolytisch in Poren, die sich während der Schichtbildung in der Oxidschicht ausbilden, abzuscheiden, wobei das erste Metall die Poren nur teilweise füllt. Anschließend wird das zweite Metall für die Metallschicht stromlos unter Auffüllung der Poren abgeschieden, wobei die Haftfestigkeit aufgrund des guten Anhaftens des zweiten Metalls an dem ersten Metall bewirkt wird.
Wesentlich ist in diesem Verfahren eine elektrolytische Vorfüllung der Poren in der Oxidschicht mit einem ersten Metall, an dem das Metall für die Metallschicht gut haftet.

Aufgabe der Erfindung ist es daher, ein Verfahren vorzuschlagen, das mittels Plasmaunterstützung arbeitet, um die gewünschten Vorzüge der dadurch erzielbaren Schichtsysteme zu genießen, gleichzeitig jedoch eine verbesserte Haftfestigkeit auf dem Untergrund aufweist. Diese Aufgabe wird gelöst durch ein Verfahren zur Beschichtung von Körpern aus Leichtmetailen oder Leichtmetailegierungen mittels Plasmaunterstützung, bei dem auf dem Körper eine Metalloxidzwischenschicht erzeugt wird, anschließend eine Trocknung durchgeführt wird und danach dann ein plasmaunterstützter Beschichtungsschritt die gewünschte Oberflächenschicht bildet.

Besonders vorteilhaft läßt sich dieses Verfahren dann einsetzen, wenn als Leichtmetall oder Leichtmetallegierung Aluminium oder eine Aluminiumlegierung eingesetzt wird, das Poren aufweist.

Gerade bei dem Einsatz von Aluminium und Aluminiumlegierungen ist es darüber hinaus ganz besonders vorteilhaft, wenn die Metalloxidzwischenschicht aus dem Aluminium bzw. der Aluminiumlegierung mittels anodischer Oxidation aufgebaut wird.

Gerade bei dieser besonders bevorzugten Ausführungsform der Erfindung wird nämlich von einem Verfahren Gebrauch gemacht, das vielfach erprobt und sehr zuverlässig ist, nämlich dem als sogenanntes Eloxalverfahren bekannten Verfahren, Aluminium zu oxidieren. An sich hätte man annehmen können - offenbar war auch die Fachwelt davon ausgegangen - daß ein zunächst mittels Eloxalverfahrens oxidierter und dadurch eine Aluminiumoxidschicht aufweisender Körper diese Oxidschicht sofort unter Plasmaeinfluß wieder verliert. Die im Plasma aktivierten lonen und Atome sollten aufgrund der Ihnen innewohnenden Energien die Eloxalschicht wieder zerstören oder aber umgekehrt die Oxidschichten für diese lonen und Atome einfach nicht zugänglich sein.

Versuche haben jedoch gezeigt, daß dieser Effekt nicht eintritt, ganz im Gegenteil. Die angestellten Untersuchungen lassen vermuten, daß die ersten schichtbildenden Atome, die in dem plasmaunterstützten Beschichtungsschritt auf die Oxidschicht auftreffen, in die dort vorhandenen Poren eindringen und sich dabei fest in ihr verklammern. Mit zunehmender Dauer wachsen die atomaren und/oder molekularen Schichten aus den Poren und damit aus der Oxidschicht heraus und bilden ein geschlossenes Schichtsystem auf der Oxidschicht. Die in die Poren eingelagerten Atome und Moleküle dagegen erfahren einen Verbund in die Oxidschicht hinein.

Die Oxidschicht selbst ist zum Grundsubstrat hin geschlossen, wodurch die Korrosion weitgehend verhindert wird. Die Poren reichen zwar tief in die Oxidschicht hinein, sie werden beim Eloxalverfahren ja automatisch mit gebildet und können in ihrer Tiefe und Form durch entsprechende Variation des Oxidierungsverfahrens in weiten Grenzen vorgegeben werden. Sie reichen bei richtiger Verfahrensweise aber nicht bis zum Grundsubstrat hindurch.

Werden die Poren wie bevorzugt nach der plasmaunterstützten Beschichtung noch nachträglich verdichtet, so tritt eine Hydratisierung der Poren ein. Haftfestigkeit und Korrosionsbeständigkeit lassen sich durch diese Verdichtung nochmals deutlich verbessern. Das Verfahren weist jedoch auch ohne eine solche Verdichtung die gewünschten Vorteile auf.

Das erfindungsgemäße Verfahren hat den Vorteil, reproduzierbar und ohne übermäßige Investitionen durchführbar zu sein.

Das erfindungsgemäße Verfahren ist ökologisch und wirtschaftlich. Die entstehenden Schichten auf den Körpern besitzen eine hohe Haftfestigkeit und Korrosionsbeständigkeit, wobei sogar gleichzeitig noch die Oberflächenhärte des Grundwerkstoffes erhöht wird.

Als Anwendungsfälle sind beispielsweise Wärmetauscher geeignet. Diese können mit aggressiven Medien in Berührung kommen und neigen zu Kalkablagerungen. Für den Kontakt mit den aggressiven Medien benötigen die Wärmetauscher eine entsprechend dagegen resistente Beschichtung, die aber auch sehr haftfest sein muß, da die Kalkablagerungen abgereinigt werden müssen.

Versuche ergaben schon, daß die entstehenden Schichtsysteme ein angenehmes Oberflächenfinish aufweisen.

Das anodische Oxidierungsverfahren, das die Poren bildet, hinterläßt zunächst in den Poren eine wässrige Flüssigkeit. Anders als bei üblichen Eloxalverfahren wird gemäß dem erfindungsgemäßen Verfahren diese Flüssigkeit aus den Poren herausgenommen, es erfolgt also eine Trocknung. Diese Trocknung kann eine übliche und unter bekannten Voraussetzungen vorgenommene sogenannte "normale" Trocknung oder aber eine Vakuumtrocknung sein. Wie bei Eloxalverfahren sonst auch üblich, wird vor der eigentlichen naßchemischen Oxidation ein Entfettungs-, Beiz- und Dekapierprozeß vorgenommen, um anschließend die Oxidation besonders zweckmäßig durchführen zu können.

Anodische Oxidierungsverfahren, wie das Eloxalverfahren, sind nicht giftig, anders als beispielsweise Verfahren, bei denen eine Chromatierung vorgenommen wird. Sie werden auch vollständig technisch beherrscht und führen heutzutage nicht zu Umweltproblemen.

Die bevorzugt einzustellenden Daten sind derart, daß eine Schichtdicke der Metalloxidzwischenschicht von etwa 1 µm bis 200 µm eingestellt wird, wobei eine Schichtdicke von 6 µm bevorzugt wird. In der Metalloxidzwischenschicht bilden sich Poren von etwa 5 µm bis 200 µm Tiefe. Ist die Schichtdicke 6 µm, wird eine Tiefe der Poren von etwa 5 µm bevorzugt. Die Tiefe der Poren ist dann fast so groß wie die Schichtdicke, nach wie vor aber geringer als diese, so daß der Korrosionsschutz in vollem Umfang gewahrt bleibt.

Neben Aluminium als Leichtmetall für den Körper bieten sich auch noch andere Leichtmetalle oder Leichtmetallegierungen wie z. B. Magnesium oder Titan an, wobei Aluminium aber aufgrund des bekannten und beherrschten anodischen Oxidierungsverfahrens bevorzugt bleibt.

Im folgenden wird anhand eines Ausführungsbeispiels die Erfindung im einzelnen erläutert: Es zeigen:
- **Figur 1**: einen Schnitt durch den Körper nach dem ersten und vor dem zweiten Verfahrensschritt; und
- **Figur 2**: einen Schnitt durch den Körper nach Abschluß des Verfahrens.

Das erfindungsgemäße Verfahren sei anhand eines ausgewählten Beispiels mit einigen Zahlenangaben erörtert, die aber keineswegs einschränkend wirken sollen. Als Probematerial bei einigen Versuchen dienten Aluminiumscheiben der Legierung AlMgSi 0,5. Diese Aluminiumscheiben wurden zunächst alkalisch entfettet, dann alkalisch gebeizt und schließlich in Salpetersäure dekapiert.

An diese Vorbehandlung schließt sich dann eine anodische Oxidation an. Die Stromdichten und die Badtemperatur der anodischen Oxidation werden dem Anwendungsfall angepaßt. Bei den Versuchen lagen sie beispielsweise zwischen einer Stromdichte von I = 0,5 bis 3 A/dm² und bei einer Temperatur von T = -10 °C bis + 20 °C.

Die anodische Oxidation wird in einem schwefelsauren Bad mit folgenden Parametern durchgeführt: Der Anteil an Schwefelsäure betrug H₂SO₄ = 200 g/l. Der Anteil an Aluminium betrug 8 g/l. Die Stromdichte wurde zu 1,2 A/dm² gewählt, die Temperatur T = 18 °C und die Zeitdauer t zu 18 Minuten.

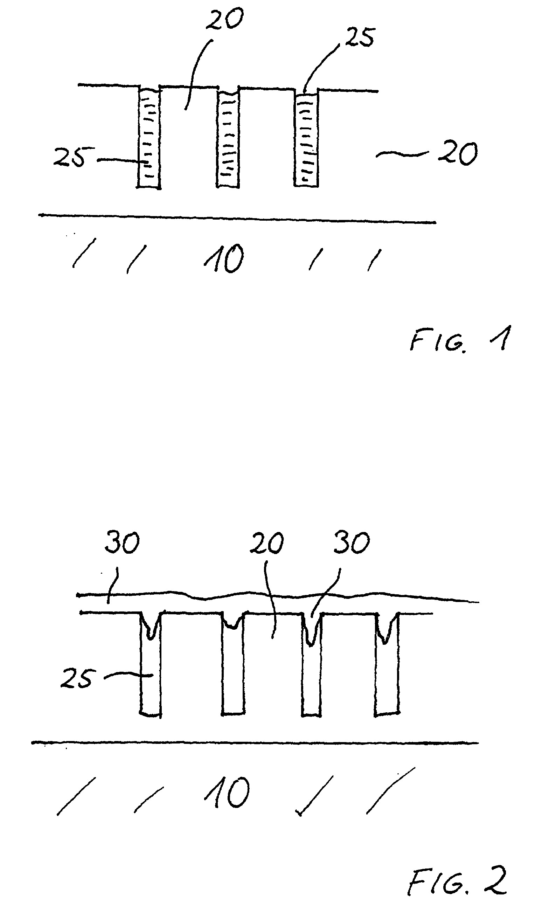

Das Aluminiumoxid Al₂O₃ entsteht durch eine elektrochemische Anodisation aus dem Aluminiumsubstrat heraus und bildet dadurch chemisch eine feste Einheit mit dem Aluminium, was die Haftfestigkeit dieser Metalloxidzwischenschicht natürlich erheblich begünstigt. Die entstehende Oxidschicht ist 6 µm dick, offen, porös, wobei die Poren mit Wasser gefüllt sind. Dies zeigt **Figur 1,** wobei unten der Körper 10 aus Leichtmetall oder einer Leichtmetallegierung, im vorliegenden Beispiel aus einem Aluminiumsubstrat dargestellt ist. Nicht maßstabsgetreu wächst auf diesem Aluminiumsubstrat bzw. auf dem Körper 10 eine Metalloxidzwischenschicht 20, hier aus Al₂O₃. Wie bei Eloxalverfahren leicht einstellbar, bilden sich Poren 25, die von relativ geringem Durchmesser, aber relativ großer Tiefe sind. Diese Poren 25 sind mit Wasser gefüllt.

Für das erfindungsgemäße Verfahren werden die offenen Poren 25 der Metalloxidzwischenschicht 20 im weiteren Verlauf von dem darin enthaltenen Wasser befreit werden. Dies erfolgt in einem Ofen bei ca.100 °C, vorzugsweise in einem Vakuumofen. Als Ergebnis liegt dann eine Metalloxidzwischenschicht vor, deren Poren wasserfrei sind. Zu diesem Zeitpunkt ist die Metalloxidzwischenschicht natürlich noch die äußerste, den Körper 10 rundum umgebende Oberflächenschicht.

Nachdem die Poren 25 wasserfrei sind, ist ein Zustand erreicht, der eine plasmaunterstützte Beschichtung erlaubt und begünstigt. In dem Ausführungsbeispiel wurde als plasmaunterstütztes Beschichtungsverfahren das Gasflußsputterverfahren mit Kupfer als Schichtsystem gewählt. Nach dem plasmaunterstützten Beschichtungsschritt ergibt sich das in **Figur 2** dargestellte Modell des Schichtsystems.

Zu erkennen ist wiederum der Körper 10, unverändert mit der Metalloxidzwischenschicht 20 und den Poren 25, die jetzt wasserfrei sind. Zu erkennen ist, daß eine Oberflächenschicht 30 sich gebildet hat, die nach unten in die Poren 25 der Metalloxidzwischenschicht 20 hineinragt. Dadurch bildet sich eine feste Verklammerung.

Die Prüfung der Haftfestigkeit erfolgt mittels einer praxisrelevanten Meßmethode. Dabei wird ein Klebestreifen auf die Oberflächenschicht 30 des Schichtsystems aufgerieben und anschließend ruckartig wieder abgezogen.

Bei der Durchführung herkömmlicher Verfahren enthaftet die Schicht teilweise bis auf das Grundsubstrat, also dem Körper 10, anders dagegen nach dem erfindungsgemäßen Verfahren: Hier konnten wesentlich bessere Haftfestigkeiten zum Körper 10 festgestellt werden.

Eine weitere Verbesserung der Haftfestigkeit ließ sich erreichen, wenn dem Verfahren noch eine Verdichtung nachgeschaltet wird.

Ein weiterer Aspekt ist der Korrosionsschutz. Wird Kupfer auf Aluminium abgeschieden, entsteht ein Korrosionselement. Das Korrosionselement ist ein galvanisches Element, daß sich bei der Korrosion eines metallischen Werkstoffes automatisch aufbaut. Es besteht aus Anode, Kathode und einem Elektrolyten. Als Elektrolyt reicht feuchte Umgebungsluft aus, damit sich Kupfer als Kathode und Aluminium als Anode ausbilden kann. Aluminium oxidiert zum lon Al³⁺ + 3 e⁻ um. Der so ausgelöste Korrosionsprozeß führt zum Versagen des Bauteils. Durch einen Nichtleiter, beispielsweise die erfindungsgemäße Metalloxidzwischenschicht 20, zwischen den Metallen, hier also der Oberflächenschicht 30 und dem Körper 10 läßt sich der Stromfluß unterbinden. Im vorliegenden Beispiel führt die Abscheidung von Kupfer auf Aluminium normalerweise zu erheblicher Korrosion. Wird aber das Aluminium wie erfindungsgemäß zunächst oxidiert und dann plasmaunterstützt mit Kupfer beschichtet, läßt sich eine erhebliche Verbesserung des Korrosionsschutzes erreichen.

### Bezugszeichenliste

- 10: Körper
- 20: Metalloxidzwischenschicht
- 25: Poren
- 30: Oberflächenschicht

## Patentansprüche

1. Verfahren zur Beschichtung von Körpern aus Leichtmetallen oder Leichtmetallegierungen mittels Plasmaunterstützung
- bei dem auf dem Körper (10) eine Metalloxidzwischenschicht (20) mittels anodischer Oxidation erzeugt wird,
- anschließend eine Trocknung durchgeführt wird und
- danach dann ein plasmaunterstützter Beschichtungsschritt die gewünschte Oberflächenschicht (30) bildet.

2. Verfahren nach Anspruch 1,
**dadurch gekennzeichnet,**
**daß** als Leichtmetall oder Leichtmetallegierung Aluminium oder eine Aluminiumlegierung eingesetzt wird.

3. Verfahren nach einem der vorstehenden Ansprüche,
**dadurch gekennzeichnet,**
**daß** die Trockung als normale Trocknung oder als Vakuumtrockung durchgeführt wird.

4. Verfahren nach einem der vorstehenden Ansprüche,
**dadurch gekennzeichnet,**
**daß** nach dem plasmaunterstützten Beschichtungsschritt eine Weiterbehandlung mit oder ohne Verdichtung der Metalloxidzwischenschicht (20) erfolgt.

## Claims

1. Method of coating bodies made of light metals or light metal alloys by means of plasma enhancement
- whereby a metal oxide intermediate layer (20) is produced on the body (10) by means of anodic oxidation,
- then drying is effected and
- subsequently a plasma-enhanced coating step then forms the desired surface layer (30).

2. Method according to claim 1,
**characterized in**
**that** as a light metal or light metal alloy aluminium or an aluminium alloy is used.

3. Method according to one of the preceding claims,
**characterized in**
**that** the drying is effected in the form of normal drying or vacuum drying.

4. Method according to one of the preceding claims,
**characterized in**
**that** after the plasma-enhanced coating step a further treatment is effected with or without compression of the metal oxide intermediate layer (20).

## Revendications

1. Procédé destiné à revêtir des corps de métaux légers ou d'alliages de métaux légers au moyen d'un renforcement de plasma
- dans lequel une couche intermédiaire d'oxyde métallique (20) est produite sur le corps (10) grâce à une oxydation anodique,
- on effectue ensuite un séchage et
- après quoi la couche superficielle souhaitée (30) est formée par une étape de revêtement par renforcement de plasma.

2. Procédé selon la revendication 1, **caractérisé en ce que** l'on utilise de l'aluminium ou un alliage d'aluminium comme métal léger ou alliage de métal léger.

3. Procédé selon l'une quelconque des revendications précédentes, **caractérisé en ce que** le séchage est effectué en tant que séchage normal ou séchage sous vide.

4. Procédé selon l'une quelconque des revendications précédentes, **caractérisé en ce que**, suite à l'étape de revêtement par renforcement de plasma, il se produit un traitement ultérieur avec ou sans étanchement de la couche intermédiaire d'oxyde métallique (20).
